# EUROPEAN PATENT SPECIFICATION

(11) **EP 4 228 900 B1**
(45) Date of publication and mention of the grant of the patent: **30.09.2026**
(21) Application number: 21881259.2
(22) Date of filing: 18.10.2021
(51) Int. Cl.: H10N 30/076, H10N 30/079, H10N 30/00, H03H 3/02

(54) **METHODS FOR DEPOSITING PIEZOELECTRIC MATERIALS, AND MATERIALS DEPOSITED THEREWITH**
VERFAHREN ZUR ABSCHEIDUNG VON PIEZOELEKTRISCHEN MATERIALIEN UND DAMIT ABGESCHIEDENE MATERIALIEN
PROCÉDÉS DE DÉPÔT DE MATÉRIAUX PIÉZOÉLECTRIQUES ET MATÉRIAUX DÉPOSÉS À L'AIDE DE CEUX-CI

(30) Priority: 16.10.2020 US 202063092820 P
(43) Date of publication of application: 23.08.2023
(73) Proprietor: QORVO US, INC., Greensboro, NC 27409 (US)
(72) Inventor: DENIZ, Derya, Plymouth, Minnesota 55447 (US); BELSICK, John, Plymouth, Minnesota 55447 (US); WASILIK, Matthew, Plymouth, Minnesota 55447 (US); DIEP, Buu Quoc, Plymouth, Minnesota 55447 (US)
(74) Representative: D Young & Co LLP
(86) International application number: PCT/US2021/055368
(87) International publication number: WO 2022/082089

(56) References cited:
- WO-A1-2017/066448
- WO-A1-2021/050828
- US-A1- 2008 197 750
- US-A1- 2018 048 280
- US-A1- 2019 296 707
- US-A1- 2019 296 710
- US-B2- 10 267 770
- US-B2- 7 307 369
- US-B2- 9 508 864

## Description

### Cross Reference to Related Applications

This application claims the benefit of U.S. Provisional Patent Application No., 63/092,820, filed 16 October 2020.

### Field

The present disclosure relates to methods of depositing piezoelectric materials. In particular, the present disclosure relates to systems for depositing piezoelectric materials with inclined c-axis and a surface roughness.

### Background

Hexagonal crystal structure piezoelectric materials such as AlN and ZnO are of commercial interest due to their piezoelectric and electroacoustic properties. A primary use of electroacoustic technology has been in the telecommunication field (e.g., for oscillators, filters, delay lines, etc.). More recently, there has been a growing interest in using electroacoustic devices in high frequency sensing applications due to the potential for high sensitivity, resolution, and reliability. However, it is not trivial to apply electroacoustic technology in certain sensor applications - particularly sensors operating in liquid or viscous media (e.g., chemical and biochemical sensors) - since longitudinal and surface waves exhibit considerable acoustic leakage into such media, thereby resulting in reduced resolution.

In the case of a piezoelectric crystal resonator, an acoustic wave may embody either a bulk acoustic wave (BAW) propagating through the interior (or 'bulk') of a piezoelectric material, or a surface acoustic wave (SAW) propagating on the surface of the piezoelectric material. SAW devices involve transduction of acoustic waves (commonly including two-dimensional Rayleigh waves) utilizing interdigital transducers along the surface of a piezoelectric material, with the waves being confined to a penetration depth of about one wavelength. BAW devices typically involve transduction of an acoustic wave using electrodes arranged on opposing top and bottom surfaces of a piezoelectric material. In a BAW device, different vibration modes can propagate in the bulk material, including a longitudinal mode and two differently polarized shear modes, wherein the longitudinal and shear bulk modes propagate at different velocities. The longitudinal mode is characterized by compression and elongation in the direction of the propagation, whereas the shear modes consist of motion perpendicular to the direction of propagation with no local change of volume. The propagation characteristics of these bulk modes depend on the material properties and propagation direction respective to the crystal axis orientations. Because shear waves exhibit a very low penetration depth into a liquid, a device with pure or predominant shear modes can operate in liquids without significant radiation losses (in contrast with longitudinal waves, which can be radiated in liquid and exhibit significant propagation losses). Restated, shear mode vibrations are beneficial for operation of acoustic wave devices with fluids because shear waves do not impart significant energy into fluids.

Certain piezoelectric thin films are capable of exciting both longitudinal and shear mode resonance. To excite a wave including a shear mode using a standard sandwiched electrode configuration device, a polarization axis in a piezoelectric thin film must generally be nonperpendicular to (e.g., tilted relative to) the film plane. Hexagonal crystal structure piezoelectric materials such as (but not limited to) aluminum nitride (AlN) and zinc oxide (ZnO) tend to develop their polarization axis (i.e., c-axis) perpendicular to the film plane, since the (0001) plane typically has the lowest surface density and is thermodynamically preferred. Certain hightemperature processes may be used to grow tilted c-axis films, but providing full compatibility with microelectronic structures such as metal electrodes or traces requires a low temperature deposition process (e.g., typically below about 300 °C).

Low temperature deposition methods such as reactive radio frequency magnetron sputtering have been used for preparing tilted AlN films. However, these processes tend to result in deposition angles that vary significantly with position over the area of a substrate, which leads to a c-axis direction of the deposited piezoelectric material that varies with radial position of the target to the source.

One effect of the lack of uniformity of c-axis tilt angle of the AlN film structure over the substrate is that if the AlN film-covered substrate were to be diced into individual chips, the individual chips would exhibit significant variation in c-axis tilt angle and concomitant variation in acoustic wave propagation characteristics. Such variation in c-axis tilt angle would render it difficult to efficiently produce large numbers of resonator chips with consistent and repeatable performance.

Improved methods and systems for producing bulk films with c-axis tilt have been described, where the c-axis tilt of the bulk layer is primarily controlled by controlling the deposition angle. For example, a device and method for depositing seed and bulk layers with a tilted c-axis are described in US9922809 B2 entitled "Deposition System for Growth of Inclined C-Axis Piezoelectric Material Structures;" US10541662 B2 entitled "Methods for Fabricating Acoustic Structure with Inclined C-Axis Piezoelectric Bulk and Crystalline Seed Layers;" US10574204 B2 entitled "Acoustic Resonator Structure with Inclined C-Axis Piezoelectric Bulk and Crystalline Seed Layers;" US10541663 B2 entitled "Multi-Stage Deposition System for Growth of Inclined C-Axis Piezoelectric Material Structures;" and US10063210 B2 entitled "Methods for Producing Piezoelectric Bulk and Crystalline Seed Layers of Different C-Axis Orientation Distributions." WO 2021/050828 A1 discloses piezoelectric bulk layers with tilted c-axis orientation, and methods for making the same.

Further improvements to deposition methods are desired.

### Brief Description of Drawings

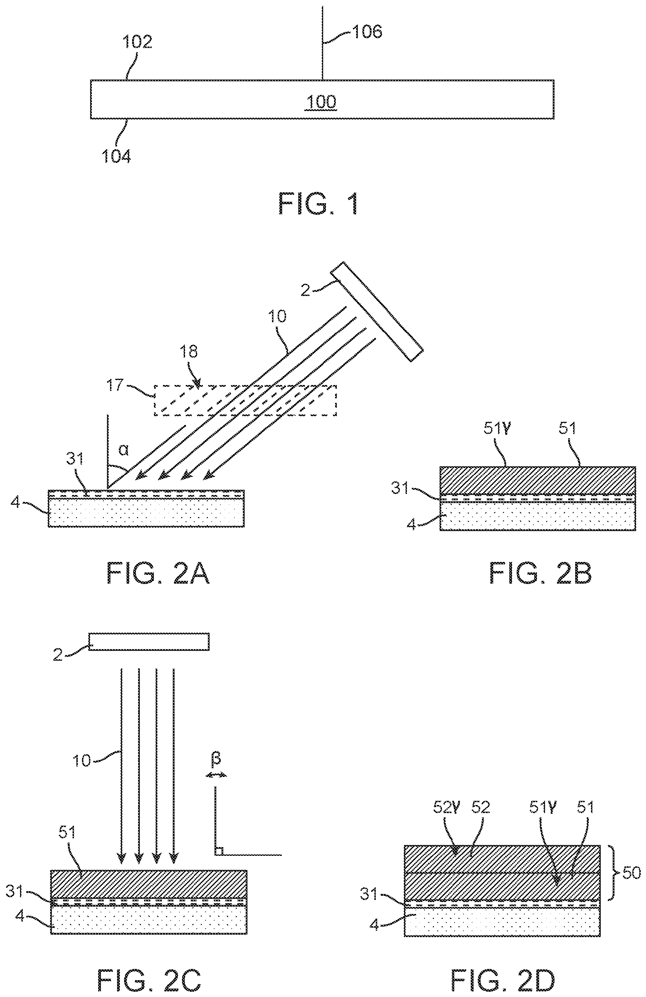

FIG. 1 shows a substrate and a normal axis thereto.
FIGS. 2A-2D are schematic views illustrating a process for depositing a bulk layer on a substrate having a seed layer to achieve a desired c-axis tilt in accordance with an embodiment described herein.

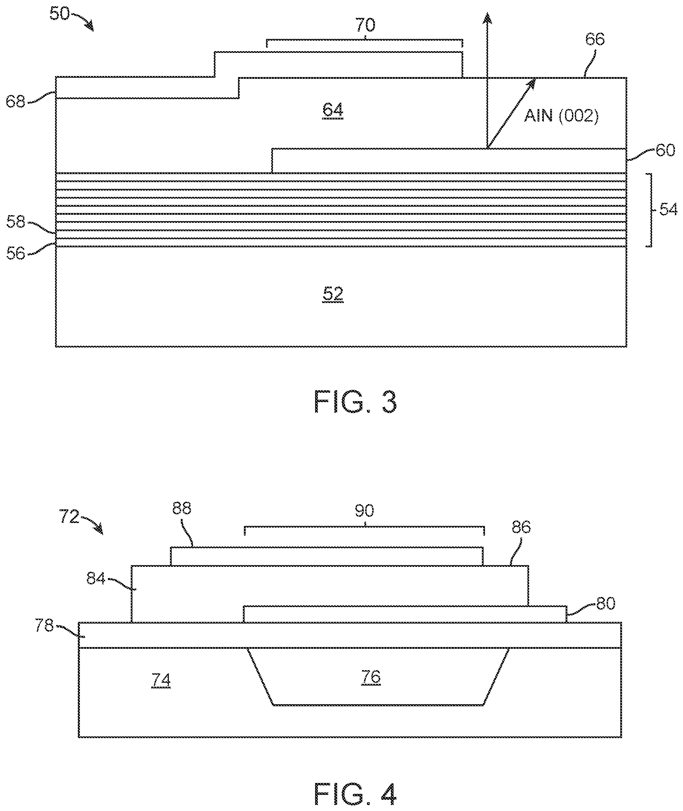

FIG. 3 is a schematic cross-sectional view of a portion of a bulk acoustic wave solidly mounted resonator device including an inclined c-axis hexagonal crystal structure piezoelectric material bulk layer as disclosed herein, with the resonator device including an active region with a portion of the piezoelectric material arranged between overlapping portions of a top side electrode and a bottom side electrode.
FIG. 4 is a schematic cross-sectional view of a film bulk acoustic wave resonator (FBAR) device according to one embodiment including an inclined c-axis hexagonal crystal structure piezoelectric material bulk layer arranged over a crystalline seed layer as disclosed herein, with the FBAR device including a substrate defining a cavity covered by a support layer, and including an active region registered with the cavity with a portion of the piezoelectric material arranged between overlapping portions of a top side electrode and a bottom side electrode.

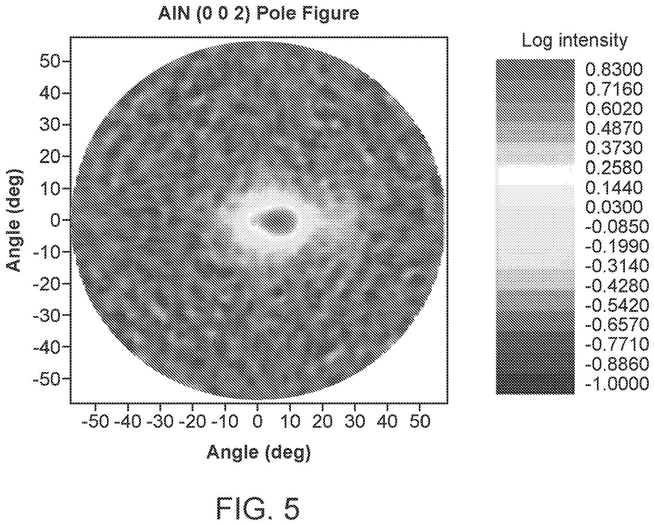

FIG. 5 is a AlN c-axis (002) XRD pole figure collected on baseline composite film consisting of seed and bulk layers exhibiting a tilt behavior of about 10° due to smoothing of the bottom electrode from CMP process.

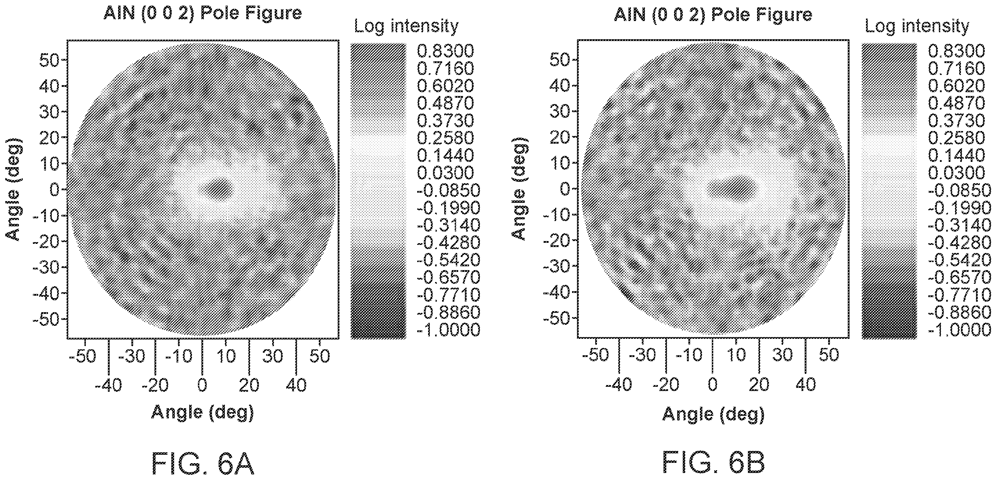

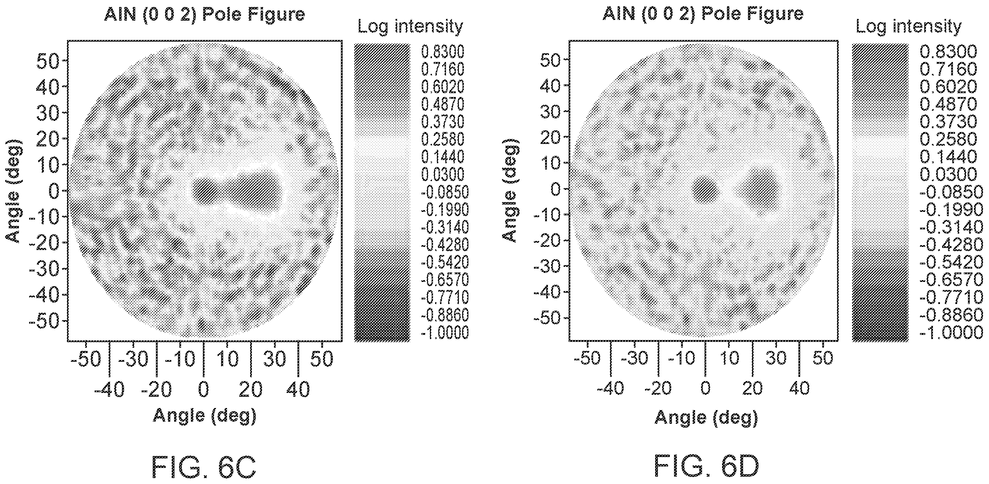

FIGs. 6A, 6B, 6C, and 6D are AlN (002) XRD pole figures illustrating the progression of the c-axis tilt of the composite films deposited on wafers as a function of the pre-seed thicknesses in angstroms (FIG. 6A has a pre-seed thickness of 10 Angstroms (Å), FIG. 6B has a pre-seed thickness of 30 Å, FIG. 6C has a pre-seed thickness of 50 Å, and FIG. 6D has a pre-seed thickness of 70 Å). Note that all these wafers have received the same BE CMP processes.

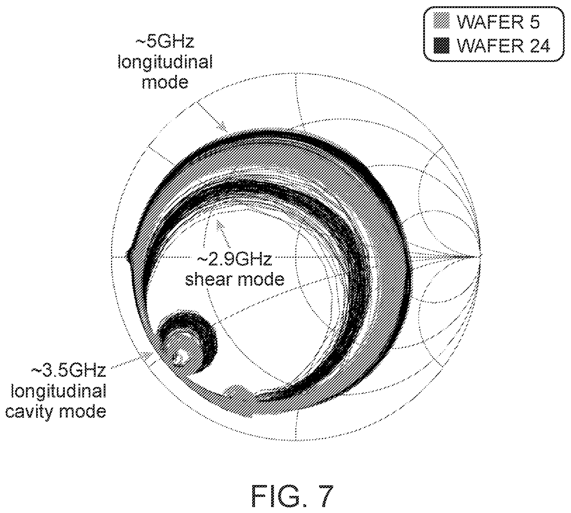

FIG. 7 is S11 traces of wafer having pre-seed layer of 50A at high pressure (WAFER 5) and wafer having no pre-seed layer at high pressure (WAFER 24). The Longitudinal and shear modes of WAFER 5 are indistinguishable. The shear mode of WAFER 5 is greater than that of WAFER 24. Note also that the shear mode of WAFER 5 is comparable to longitudinal mode of WAFER 24.

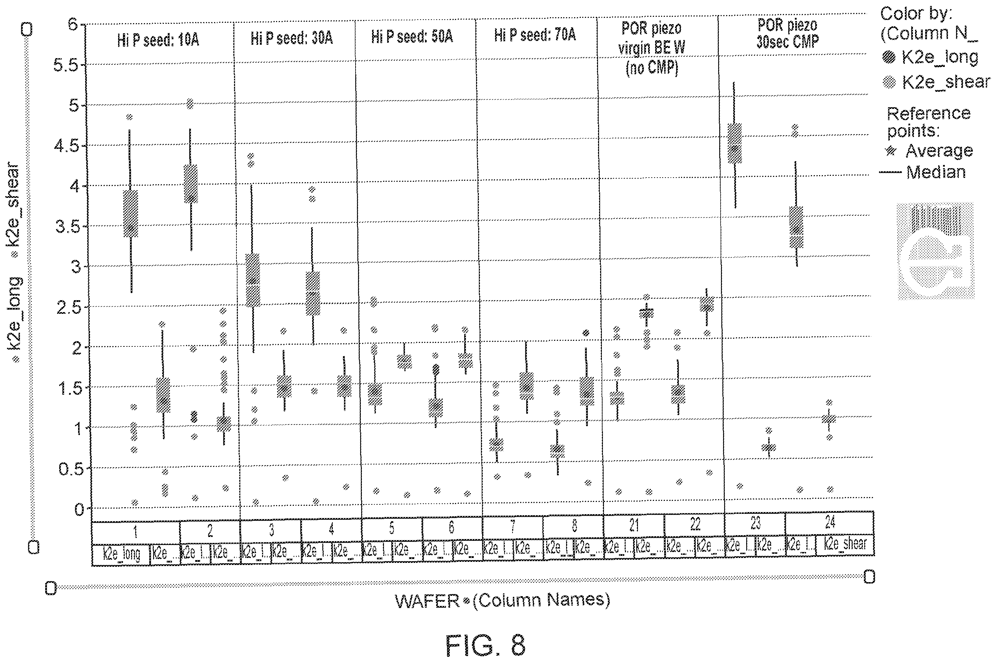

FIG. 8 is the corresponding longitudinal and shear piezoelectric coefficients as a function of wafer splits for wafers shown in FIG. 6 along with the splits grown on virgin W bottom electrode. The longitudinal response is suppressed, and shear response is improved best with the splits, WAFER 5 and 6 that have received a pre-seed layer of 50A at high pressure. The improvement results in a superior performance with respect to the baseline, WAFER 23 and 24, having no pre-seed layer at high pressure.

### Summary

A system and method for depositing piezoelectric materials onto wafer substrates are described. The system and method may be used to deposit piezoelectric materials including layers of inclined c-axis and normal incidence piezoelectric material.

The depositing of material onto the wafer substrate at an inclined c-axis may include depositing a seed layer. The depositing of material onto the wafer substrate at normal incidence may include depositing a bulk layer.

Disclosed herein are a method of depositing material onto a substrate, the method comprising: depositing a first seed material onto a wafer substrate to form a pre-seed layer on the wafer substrate prior to a seed layer, the wafer substrate having a face that defines a normal to the substrate, wherein the first seed material is deposited at a pressure of 10 mTorr to 20 mTorr, wherein the pre- seed layer has a surface roughness from 1 nm to 10 nm; depositing a second seed material onto at least a portion of the pre-seed layer at an off-normal incidence angle to form the seed layer on at least a portion of the pre-seed layer; and depositing a bulk piezoelectric material onto at least a portion of the seed layer to form a bulk piezoelectric layer having a c-axis tilt of 35 degrees or greater and a surface roughness of 4.5 nm or less.

Also disclosed are methods wherein the first seed material is deposited at a pressure of 12 mTorr to 18 mTorr, 14 mTorr to 16 mTorr, or even 15 mTorr. Also disclosed are methods wherein the surface roughness of the pre-seed layer is from 3 nm to 5 nm, or even from 3 nm to 4 nm. Also disclosed are methods wherein the second seed material is deposited at a pressure of less than 5 mTorr, less than 3 mTorr, less than 2 mTorr, or even 1.5 mTorr. Also disclosed are methods wherein the second seed material is deposited at an off-normal incidence angle of greater than 10 degrees, greater than 27 degrees, greater than 30 degrees, greater than 32 degrees, greater than 33 degrees, greater than 34 degrees, greater than 35 degrees, greater than 36 degrees, or greater than 40 degrees. Also disclosed are methods wherein the second seed material is deposited at an off-normal incidence angle of up to 85 degrees, up to 75 degrees, up to 65 degrees, up to 56 degrees, up to 52 degrees, up to 50 degrees, up to 49 degrees, or up to 48 degrees. Also disclosed are methods wherein the bulk piezoelectric material is deposited at an off-normal angle of incidence. Also disclosed are methods wherein the bulk piezoelectric material is deposited at an angle of 0 degrees, up to 5 degrees, up to 10 degrees, up to 15 degrees, up to 20 degrees, up to 25 degrees, up to 30 degrees, up to 35 degrees, or up to 40 degrees. Also disclosed are methods wherein the bulk piezoelectric material is deposited at a pressure of less than 5 mTorr, less than 3 mTorr, less than 2 mTorr, or even 1.5 mTorr. Also disclosed are methods wherein the bulk piezoelectric layer comprises a hexagonal crystal structure piezoelectric material having a c-axis having an orientation distribution predominantly in a range of from 12 degrees to 52 degrees, or in a range of from 27 degrees to 37 degrees, or in a range of from 75 degrees to 90 degrees, relative to the normal of the face of the substrate. Also disclosed are methods wherein the bulk piezoelectric layer is 1,000 Angstroms to 30,000 Angstroms thick and wherein the thickness varies by less than 2 % over an area of the bulk piezoelectric layer. Also disclosed are methods wherein the first seed material, the second seed material and the bulk piezoelectric material are the same or different and are selected from metal nitrides, metal oxides, metal oxynitrides, metal carbides, refractory metals, and combinations thereof. Also disclosed are methods wherein materials of the first seed material, the second seed material and the bulk piezoelectric material are the same or different and are selected from aluminum nitride, titanium nitride, hafnium nitride, tantalum nitride, zirconium nitride, vanadium nitride, niobium nitride, gallium nitride, zinc oxide, tungsten oxide, hafnium oxide, molybdenum oxide, hafnium oxynitride, titanium oxynitride, tantalum oxynitride, titanium carbide, niobium carbide, tungsten carbide, tantalum carbide, zirconium, hafnium, tungsten, molybdenum, and combinations thereof.

Also disclosed are piezoelectric structures comprising: a substrate comprising a wafer or a portion thereof, the substrate having a face that defines normal to the substrate; a pre-seed layer on at least a portion of the substrate, the pre-seed layer being deposited prior to a seed layer and having a surface roughness from 1 nm to 10 nm; a seed layer on at least a portion of the pre-seed layer, the seed layer having a first c-axis tilt; and a bulk piezoelectric layer having a second c-axis tilt of 35 degrees or greater and comprising an outer surface having a surface roughness of 4.5 nm or less.

Also disclosed are structures wherein the surface roughness of the pre-seed layer is from 3 nm to 5 nm, or even from 3 nm to 4 nm. Also disclosed are structures wherein the seed layer has a first c-axis tilt and the bulk piezoelectric layer has a second c-axis tilt that substantially aligns with the first c-axis tilt. Also disclosed are structures wherein the second c-axis tilt is 35 degrees to 52 degrees. Also disclosed are structures wherein the bulk piezoelectric layer comprises a hexagonal crystal structure piezoelectric material having a c-axis having an orientation distribution predominantly in a range of from 12 degrees to 52 degrees, or in a range of from 27 degrees to 37 degrees, or in a range of from 75 degrees to 90 degrees, relative to the normal of the face of the substrate. Also disclosed are structures wherein the bulk piezoelectric layer is 1,000 Angstroms to 30,000 Angstroms thick and wherein the thickness varies by less than 2 % over an area of the bulk piezoelectric layer. Also disclosed are structures wherein materials of the pre-seed layer, the seed layer and the bulk piezoelectric layer are the same or different and are selected from metal nitrides, metal oxides, metal oxynitrides, metal carbides, refractory metals, and combinations thereof. Also disclosed are structures wherein materials of the pre-seed layer, the seed layer and the bulk piezoelectric layer are the same or different and are selected from aluminum nitride, titanium nitride, hafnium nitride, tantalum nitride, zirconium nitride, vanadium nitride, niobium nitride, gallium nitride, zinc oxide, tungsten oxide, hafnium oxide, molybdenum oxide, hafnium oxynitride, titanium oxynitride, tantalum oxynitride, titanium carbide, niobium carbide, tungsten carbide, tantalum carbide, zirconium, hafnium, tungsten, molybdenum, and combinations thereof.

Also disclosed are bulk acoustic wave ("BAW") devices comprising a piezoelectric structure prepared according to any disclosed methods.

### Detailed Description

The present disclosure relates to methods for depositing piezoelectric materials. In particular, the present disclosure relates to methods for depositing piezoelectric materials including inclined c-axis piezoelectric materials.

A deposition method is disclosed that allows for growth of inclined c-axis piezoelectric material structures. This method utilizes a layer deposited prior to a seed layer, referred to herein as a pre-seed layer, that is engineered to include a rough surface. The rough surface of the pre-seed layer renders a seed layer deposited thereon indifferent to incoming surface roughness variations of the bottom electrode. The pre-seed layer can be formed by depositing it at sufficiently high pressure. The higher the pressure during deposition, the rougher the resultant surface. Using methods of the present disclosure may afford c-axis piezoelectric layers that have less variation in the tilt axis behavior. Formation of more consistent c-axis piezoelectric layers provide devices that function more consistently. This can be shown via the dry response of the shear mode film at wafer level test, which facilitates parameter fitting. But even more importantly, the systems level wet response, which translates to a steeper peak-to-peak phase response, and ultimately results in less noise during the measurement can show this advantage.

The term "c-axis" is used here to refer to the (002) direction of a deposited crystal with a hexagonal wurtzite structure. The c-axis is typically the longitudinal axis of the crystal.

The terms "c-axis tilt," "c-axis orientation," and "c-axis incline" are used here interchangeably to refer to the angle of the c-axis relative to a normal of the surface plane of the deposition substrate.

When referring to c-axis tilt or c-axis orientation, it should be understood that even if a single angular value is given, the crystals in a deposited crystal layer (e.g., a seed layer or a bulk layer) may exhibit a distribution of angles. The distribution of angles typically approximately follows a normal (e.g., Gaussian) distribution that can be graphically demonstrated, for example, as a two-dimensional plot resembling a bell-curve, or by a pole figure.

The term "incidence angle" is used here to refer to the angle at which atoms are deposited onto a substrate, measured as the angle between the deposition pathway and a normal of the surface plane of the substrate.

The term "substrate" is used here to refer to a material onto which a seed layer or a bulk layer may be deposited. The substrate may be, for example, a wafer, or may be a part of a resonator device complex or wafer, which may also include other components, such as an electrode structure arranged over at least a portion of the substrate. A seed layer is not considered to be "a substrate" in the embodiments of this disclosure.

When referring to deposition of crystals "on a substrate," there may be intervening layers (e.g., a seed layer) between the substrate and the crystals. However, the expressions "directly on a substrate" or "on the surface of the substrate" are intended to exclude any intervening layers.

The term "seed layer" is used here to refer to a layer onto which a bulk material layer may be deposited.

The term "bulk layer" is used here to refer to a crystalline layer that exhibits primarily

(002) texture. The bulk layer may be formed in one or more steps. Reference to the bulk layer in this disclosure refers to the entire bulk layer, whether the bulk layer is formed in a single step, two steps, or more than two steps.

The term "pre-seed layer" is used here to refer to a layer deposited before a seed layer and can function to control at least one property of a seed layer formed thereon.

The term "vacuum" is used here to refer to a sub-atmospheric pressure condition, where atmospheric pressure is 760 Torr.

The term "substantially" as used here has the same meaning as "nearly completely," and can be understood to modify the term that follows by at least about 90 %, at least about 95 %, or at least about 98 %.

The terms "parallel" and "substantially parallel" with regard to the crystals refer to the directionality of the crystals. Crystals that are substantially parallel not only have the same or similar c-axis tilt but also point in the same or similar direction.

The term "about" is used here in conjunction with numeric values to include normal variations in measurements as expected by persons skilled in the art, and is understood have the same meaning as "approximately" and to cover a typical margin of error, such as ±5 % of the stated value.

All scientific and technical terms used herein have meanings commonly used in the art unless otherwise specified. The definitions provided herein are to facilitate understanding of certain terms used frequently herein and are not meant to limit the scope of the present disclosure.

As used here, the singular forms "a", "an", and "the" encompass embodiments having plural referents, unless the content clearly dictates otherwise.

As used here, the term "or" is generally employed in its sense including "and/or" unless the content clearly dictates otherwise. The term "and/or" means one or all of the listed elements or a combination of any two or more of the listed elements.

As used here, "have", "having", "include", "including", "comprise", "comprising" or the like are used in their open-ended sense, and generally mean "including, but not limited to." It will be understood that "consisting essentially of," "consisting of," and the like are subsumed in "comprising" and the like. As used herein, "consisting essentially of," as it relates to a composition, product, method or the like, means that the components of the composition, product, method or the like are limited to the enumerated components and any other components that do not materially affect the basic and novel characteristic(s) of the composition, product, method or the like.

The words "preferred" and "preferably" refer to embodiments of the invention that may afford certain benefits, under certain circumstances. However, other embodiments may also be preferred, under the same or other circumstances. Furthermore, the recitation of one or more preferred embodiments does not imply that other embodiments are not useful, and is not intended to exclude other embodiments from the scope of the disclosure, including the claims.

The recitations of numerical ranges by endpoints include all numbers subsumed within that range (e.g., 1 to 5 includes 1, 1.5, 2, 2.75, 3, 3.80, 4, 5, etc. or 10 or less includes 10, 9.4, 7 .6, 5, 4.3, 2.9, 1.62, 0.3, etc.). Where a range of values is "up to" a particular value, that value is included within the range.

Any direction referred to here, such as "top," "bottom," "left," "right," "upper," "lower," and other directions and orientations are described herein for clarity in reference to the figures and are not to be limiting of an actual device or system or use of the device or system. Devices or systems as described herein may be used in a number of directions and orientations.

Methods disclosed herein include a step of depositing a first seed material on a substrate, such as a wafer substrate to form a pre-seed layer. FIG. 1 shows the substrate 100 having a first face 102 and a second opposing face 104. The first face 102 defines a normal 106 to the substrate 100. The first seed material may include metal nitrides, metal oxides, metal oxynitrides, metal carbides, refractory metals, or combinations thereof. In some embodiments, the first seed material may include aluminum nitride, titanium nitride, hafnium nitride, tantalum nitride, zirconium nitride, vanadium nitride, niobium nitride, gallium nitride, zinc oxide, tungsten oxide, hafnium oxide, molybdenum oxide, hafnium oxynitride, titanium oxynitride, tantalum oxynitride, titanium carbide, niobium carbide, tungsten carbide, tantalum carbide, zirconium, hafnium, tungsten, molybdenum, or combinations thereof. In some embodiments, the first seed material may include aluminum nitride.

Deposition of the first seed material forms a pre-seed layer on the substrate. The pre-seed layer can have a thickness from 1 nm to 10 nm, from 3 nm to 5 nm, or even from 3 nm to 4 nm.

The first seed material is deposited at relatively high pressures. In some embodiments, the first seed material may be deposited at pressures of 10 mTorr to 20 mTorr, 12 mTorr to 18 mTorr, 14 mTorr to 16 mTorr, or even about 15 mTorr.

The pre-seed layer can generally be considered to have a relatively rough surface. In some embodiments, the surface roughness of the pre-seed layer can have a roughness from 1 nm to 10 nm. In some embodiments, the surface roughness of the pre-seed layer is from 3 nm to 5 nm, or even from 3 nm to 4 nm. The roughness of the pre-seed layer can influence layers that are deposited thereon.

Once the pre-seed layer has been formed, a second seed material can then be deposited thereon to form a seed layer. The second seed material may include metal nitrides, metal oxides, metal oxynitrides, metal carbides, refractory metals, or combinations thereof. In some embodiments, the second seed material may include aluminum nitride, titanium nitride, hafnium nitride, tantalum nitride, zirconium nitride, vanadium nitride, niobium nitride, gallium nitride, zinc oxide, tungsten oxide, hafnium oxide, molybdenum oxide, hafnium oxynitride, titanium oxynitride, tantalum oxynitride, titanium carbide, niobium carbide, tungsten carbide, tantalum carbide, zirconium, hafnium, tungsten, molybdenum, or combinations thereof. In some embodiments, the second seed material may include aluminum nitride. In some embodiments, the first and second seed materials can be the same and in some embodiments, the first and second seed materials can be different.

Disposition of the second seed material forms a seed layer. In some embodiments, the seed layer can have a thickness between 1000 Å and 2000 Å, from 1200 Å to 1500 Å, or from 1300 Å to 1400 Å. In some embodiments, a thickness of about 1350 Å can be utilized. In some embodiments, the ratio c can be considered. In some embodiments, a ratio of the thickness of the bulk piezoelectric layer to the thickness of the seed layer can be considered. It has been found that a bulk-seed thickness ratio of 2.3 is optimum. A bulk-seed thickness ratio less than 2.3 may have similar performance, but the seed layer takes longer to deposit. A bulk-seed layer thickness ratio higher than 2.3 can begin to degrade performance.

The second seed material is generally deposited at a much lower pressure than was the first seed material. In some embodiments, the second seed material is deposited at a pressure of less than 5 mTorr, less than 3 mTorr, less than 2 mTorr, or even about 1.5 mTorr.

The second seed material is deposited at an angle that is off-axis to the normal defined by the first face of the substrate. This can also be called an off-normal incidence angle. In some embodiments, the second seed material is deposited at an off-normal incidence angle of greater than 10 degrees, greater than 27 degrees, greater than 30 degrees, greater than 32 degrees, greater than 33 degrees, greater than 34 degrees, greater than 35 degrees, greater than 36 degrees, or greater than 40 degrees. The second seed material can be deposited at an off-normal incidence angle of to about 85 degrees, up to about 75 degrees, up to about 65 degrees, up to about 56 degrees, up to about 52 degrees, up to about 50 degrees, up to about 49 degrees, or up to about 48 degrees.

The seed layer or the material of the seed layer has a c-axis tilt. In various embodiments described herein, the seed layer is prepared such that the c-axis orientation of the crystals in the seed layer is selectable within a range of about 0 degrees to about 90 degrees, 12 degrees to 52 degrees, 27 degrees to 37 degrees, 35 degrees to 52 degrees, 75 degrees to 90 degrees, relative to the normal of the face of the substrate. The c-axis orientation distribution is preferably substantially uniform over the area of a large substrate (e.g., having a diameter in a range of at least about 50 mm or greater, about 100 mm or greater, or about 150 mm or greater), thereby enabling multiple chips to be derived from a single substrate and having the same or similar acoustic wave propagation characteristics.

After formation of the seed layer, a bulk piezoelectric material can then be deposited thereon to form a bulk piezoelectric layer. The bulk piezoelectric material may include metal nitrides, metal oxides, metal oxynitrides, metal carbides, refractory metals, or combinations thereof. In some embodiments, the bulk piezoelectric material may include aluminum nitride, titanium nitride, hafnium nitride, tantalum nitride, zirconium nitride, vanadium nitride, niobium nitride, gallium nitride, zinc oxide, tungsten oxide, hafnium oxide, molybdenum oxide, hafnium oxynitride, titanium oxynitride, tantalum oxynitride, titanium carbide, niobium carbide, tungsten carbide, tantalum carbide, zirconium, hafnium, tungsten, molybdenum, or combinations thereof. In some embodiments, the bulk piezoelectric material may include zinc oxide.

The bulk piezoelectric material is generally deposited at a much lower pressure than was the first seed material. In some embodiments, the bulk piezoelectric material is deposited at a pressure of less than 5 mTorr, less than 3 mTorr, less than 2 mTorr, or even about 1.5 mTorr.

The bulk piezoelectric material can be deposited at an off-normal incidence angle as well. In some embodiments, the bulk piezoelectric material can be deposited at an angle of about 0 degrees, up to about 5 degrees, up to about 10 degrees, up to about 15 degrees, up to about 20 degrees, up to about 25 degrees, up to about 30 degrees, up to about 35 degrees, or up to about 40 degrees.

The bulk piezoelectric layer can have a surface roughness that is 4.5 nm or less.

The bulk material layer may have a thickness of about 1,000 Angstroms to about 30,000 Angstroms. The thickness may vary by less than 2 % over an area of the bulk material layer.

In embodiments, the c-axis tilt of the bulk piezoelectric material layer is substantially aligned with the axis tilt of the seed layer. In various embodiments described herein, the bulk piezoelectric layer is prepared such that the c-axis orientation of the crystals in the bulk layer is selectable within a range of about 0 degrees to about 90 degrees, 12 degrees to 52 degrees, 27 degrees to 37 degrees, 35 degrees to 52 degrees, 75 degrees to 90 degrees, relative to the normal of the face of the substrate. The c-axis orientation distribution is preferably substantially uniform over the area of a large substrate (e.g., having a diameter in a range of at least about 50 mm or greater, about 100 mm or greater, or about 150 mm or greater), thereby enabling multiple chips to be derived from a single substrate and having the same or similar acoustic wave propagation characteristics.

Specialized deposition equipment may be used to deposit inclined c-axis piezoelectric material structures to control the c-axis orientation relative to the normal of the substrate/electrode. Such deposition is enabled by understanding the mechanism of film growth and the ability to set the film crystallographic structure. Work carried out has developed novel deposition techniques integrated with stand-alone deposition systems to accomplish this task.

The inclined c-axis hexagonal crystal structure piezoelectric material layers (and underlying structures) may be used, for example, in various resonators as well as in thin film electroacoustic and/or sensor devices. Films made with inclined c-axis hexagonal crystal structure piezoelectric materials may be particularly useful in sensors operating in liquid/viscous media, such as chemical and biochemical sensors.

In some embodiments, formation of the seed layer creates an off-normal angle of incidence to achieve a desired c-axis tilt. Once the c-axis tilt is established, the remainder of the bulk piezoelectric material can be deposited at normal incidence. Despite being deposited at normal incidence, the bulk piezoelectric material tends to adopt the c-axis tilt of the previously deposited seed layer.

Referring now to FIGS. 2A-2D, schematic diagrams for deposition of the seed layer and the bulk piezoelectric layer are shown. Deposition of the first seed material can be done using standard deposition techniques, as would be known to those of skill in the art. Deposition of the seed layer (shown in FIG. 2A) includes ejection of metal atoms from a target 2 of a linear sputtering apparatus in an off-axis module to react with a gas species forming a deposition flux 10 to be received by the pre-seed layer 31 on the substrate 4. The off-axis module may include a multi-aperture collimator 17 arranged between the target and the substrate. The deposition flux 10 may be directed through the apertures 18 of the collimator 17 to help control the incidence angle during deposition. The deposition flux 10 arrives at the substrate 4 at a first incidence angle α, forming a seed layer 51 of the film 50 (shown in FIG. 2D) on the pre-seed layer 31. The crystals of the seed layer 51 of the film 50 have a c-axis tilt 51γ.

In a second growth step (shown in FIG. 2C), metal atoms are ejected from target 2 in a longitudinal module to react with a gas species and to be received by the seed layer 51 already deposited on the pre-seed layer 31 on the substrate 4. In this deposition (or growth) step, the target 2 may be positioned such that the second incidence angle β is smaller than the first incidence angle α (e.g., is between normal and the first incidence angle α). For example, the second incidence angle β may be about 0 degrees (i.e., normal to the surface of the substrate 4). The deposition flux 10 in the second growth step form a bulk piezoelectric layer 52 of the film 50 (shown in FIG. 2D). The crystals of the bulk piezoelectric layer 52 of the film 50 have a c-axis tilt 52γ. This growth step may be done without a collimator.

According to an embodiment, the c-axis tilt 52γ of the bulk piezoelectric layer 52 follows or substantially follows the c-axis tilt 51γ of the seed layer 51 of the film 50. In some embodiments, the c-axis tilt 51γ, 52γ of the seed layer and the bulk piezoelectric layer 51, 52 aligns or at least substantially aligns with the first incidence angle α used during the first growth step. The resulting bulk layer crystals of the first portion 51 and second portion 52 may be substantially parallel to one another and at least substantially align with the desired c-axis tilt. The resulting crystals of the seed layer 51 and bulk piezoelectric layer 52 may also be substantially parallel within each portion. For example, at least 50 %, at least 75 %, or at least 90 % of the crystals of the seed layer 51 may have a c-axis tilt 51γ that is within 0 degrees to 10 degrees of the average c-axis tilt, and a direction that is within 0 degrees to 45 degrees, or within 0 degrees to 20 degrees of the average crystal direction. Similarly, at least 50 %, at least 75 %, or at least 90 % of the crystals of the bulk piezoelectric layer 52 may have a c-axis tilt 52γ that is within 0 degrees to 10 degrees of the average c-axis tilt, and a direction that is within 0 degrees to 45 degrees, or within 0 degrees to 20 degrees of the average crystal direction.

In various embodiments described herein, a structure prepared using methods of the present disclosure includes a substrate comprising a wafer, a pre-seed layer, a seed layer, and a piezoelectric bulk material layer deposited onto a surface of the wafer, where the piezoelectric bulk material layer has a c-axis tilt of about 32 degrees or greater. The structure may exhibit a ratio of shear coupling to longitudinal coupling of 1.25 or greater during excitation. The bulk piezoelectric layer may have an outer surface having a surface roughness (Ra) of 4.5 nm or less.

In various embodiments described herein, a bulk acoustic wave resonator prepared using methods of the present disclosure includes a structure including a substrate comprising a wafer, a pre-seed layer, a seed layer, and a piezoelectric bulk piezoelectric material layer deposited onto a surface of the seed layer, where the bulk material layer has a c-axis tilt of about 32 degrees or greater, where at least a portion of piezoelectric bulk material layer is between the first electrode and the second electrode. The piezoelectric bulk layer may have an outer surface having a surface roughness (Ra) of 4.5 nm or less.

The piezoelectric material films with a bulk layer made according to embodiments of the present disclosure can be used in various bulk acoustic wave ("BAW") devices, such as BAW resonators. Illustrative BAW resonators employing the piezoelectric material films of the present disclosure are shown in FIGS. 3 and 4.

FIG. 3 is a schematic cross-sectional view of a portion of a bulk acoustic wave solidly mounted resonator device 50 including a piezoelectric structure 64 including a piezoelectric material bulk layer formed as discussed above (e.g., including a pre-seed layer and a seed layer as well as a bulk piezoelectric layer) embodying an inclined c-axis hexagonal crystal structure piezoelectric material (e.g., AlN or ZnO) as disclosed herein. The c-axis (or (002) direction) of the piezoelectric material of the piezoelectric structure 64 is tilted away from a direction normal to the substrate 52, as illustrated by two arrows superimposed over the piezoelectric structure 64. The resonator device 50 includes the substrate 52 (e.g., typically silicon or another semiconductor material), the piezoelectric structure 64, and bottom and top side electrodes 60, 68. The bottom side electrode 60 is arranged between the acoustic reflector 54 and the piezoelectric structure 64, and the top side electrode 68 is arranged along a portion of an upper surface 66 of the piezoelectric structure 64. An area in which the piezoelectric structure 64 is arranged between overlapping portions of the top side electrode 68 and the bottom side electrode 60 is considered the active region 70 of the resonator device 50. The acoustic reflector 54 serves to reflect acoustic waves and therefore reduce or avoid their dissipation in the substrate 52. In certain embodiments, the acoustic reflector 54 includes alternating thin layers 56, 58 of materials of different acoustic impedances (e.g., SiOC, Si₃N₄, SiO₂, AlN, and Mo), optionally embodied in a Bragg mirror, deposited over the substrate 52. In certain embodiments, other types of acoustic reflectors may be used. Steps for forming the resonator device 50 may include depositing the acoustic reflector 54 over the substrate 52, followed by deposition of the bottom side electrode 60, followed by growth (e.g., via sputtering or other appropriate methods) of the piezoelectric structure 64, followed by deposition of the top side electrode 68.

FIG. 4 is a schematic cross-sectional view of a film bulk acoustic wave resonator (FBAR) device 72 according to one embodiment. The FBAR device 72 includes a substrate 74 (e.g., silicon or another semiconductor material) defining a cavity 76 that is covered by a support layer 78 (e.g., silicon dioxide). A bottom side electrode 80 is arranged over a portion of the support layer 78, with the bottom side electrode 80 and the support layer 78. A piezoelectric structure 84 including a piezoelectric material bulk layer formed as discussed above (e.g., including a pre-seed layer and a seed layer as well as a bulk piezoelectric layer) embodying inclined c-axis hexagonal crystal structure piezoelectric material (e.g., AlN or ZnO) is arranged over the bottom side electrode 80, and a top side electrode 88 is arranged over at least a portion of a top surface 86 of the piezoelectric structure 84. A portion of the piezoelectric structure 84 arranged between the top side electrode 88 and the bottom side electrode 80 embodies an active region 90 of the FBAR device 72. The active region 90 is arranged over and registered with the cavity 76 disposed below the support layer 78. The cavity 76 serves to confine acoustic waves induced in the active region 90 by preventing dissipation of acoustic energy into the substrate 74, since acoustic waves do not efficiently propagate across the cavity 76. In this respect, the cavity 76 provides an alternative to the acoustic reflector 54 illustrated in FIG. 3. Although the cavity 76 shown in FIG. 4 is bounded from below by a thinned portion of the substrate 74, in alternative embodiments at least a portion of the cavity 76 extends through an entire thickness of the substrate 74. Steps for forming the FBAR device 72 may include defining the cavity 76 in the substrate 74, filling the cavity 76 with a sacrificial material (not shown) optionally followed by planarization of the sacrificial material, depositing the support layer 78 over the substrate 74 and the sacrificial material, removing the sacrificial material (e.g., by flowing an etchant through vertical openings defined in the substrate 74 or the support layer 78, or lateral edges of the substrate 74), depositing the bottom side electrode 80 over the support layer 78, growing (e.g., via sputtering or other appropriate methods) the piezoelectric structure 84, and depositing the top side electrode 88.

In certain embodiments, an acoustic reflector structure is arranged between the substrate and the at least one first electrode structure to provide a solidly mounted bulk acoustic resonator device. Optionally, a backside of the substrate may include a roughened surface configured to reduce or eliminate backside acoustic reflection. In other embodiments, the substrate defines a recess, a support layer is arranged over the recess, and the support layer is arranged between the substrate and at least a portion of the at least one first electrode structure, to provide a film bulk acoustic wave resonator structure.

The following is a list of exemplary embodiments of the present disclosure:

Embodiment 1 is a method of depositing material onto a substrate, the method comprising: depositing a first seed material onto a wafer substrate, the wafer substrate having a face that defines a normal to the substrate, wherein the first seed material is deposited at a pressure of 10 mTorr to 20 mTorr to form a pre-seed layer on the wafer substrate, wherein the pre- seed layer has a surface roughness from 1 nm to 10 nm; depositing a second seed material onto at least a portion of the pre-seed layer at an off-normal incidence angle to form a seed layer on at least a portion of the pre-seed layer; and depositing a bulk piezoelectric material onto at least a portion of the seed layer to form a bulk piezoelectric layer having a c-axis tilt of about 35 degrees or greater and a surface roughness of 4.5 nm or less.

Embodiment 2 includes the methods according to Embodiment 1, wherein the first seed material is deposited at a pressure of 12 mTorr to 18 mTorr, 14 mTorr to 16 mTorr, or even about 15 mTorr.

Embodiment 3 includes the methods according to any of Embodiments 1 or 2, wherein the surface roughness of the pre-seed layer is from 3 nm to 5 nm, or even from 3 nm to 4 nm.

Embodiment 4 includes the methods according to any of Embodiments 1 to 3, wherein the second seed material is deposited at a pressure of less than 5 mTorr, less than 3 mTorr, less than 2 mTorr, or even about 1.5 mTorr.

Embodiment 5 includes the method according to any of Embodiments 1 to 4, wherein the second seed material is deposited at an off-normal incidence angle of greater than 10 degrees, greater than 27 degrees, greater than 30 degrees, greater than 32 degrees, greater than 33 degrees, greater than 34 degrees, greater than 35 degrees, greater than 36 degrees, or greater than 40 degrees.

Embodiment 6 includes the methods according to any of Embodiments 1 to 5, wherein the second seed material is deposited at an off-normal incidence angle of up to about 85 degrees, up to about 75 degrees, up to about 65 degrees, up to about 56 degrees, up to about 52 degrees, up to about 50 degrees, up to about 49 degrees, or up to about 48 degrees.

Embodiment 7 includes the methods according to any of Embodiments 1 to 6, wherein the bulk piezoelectric material is deposited at an off-normal angle of incidence.

Embodiment 8 includes the method according to any of Embodiments 1 to 7, wherein the bulk piezoelectric material is deposited at an angle of about 0 degrees, up to about 5 degrees, up to about 10 degrees, up to about 15 degrees, up to about 20 degrees, up to about 25 degrees, up to about 30 degrees, up to about 35 degrees, or up to about 40 degrees.

Embodiment 9 includes the method according to any of Embodiments 1 to 8, wherein the bulk piezoelectric material is deposited at a pressure of less than 5 mTorr, less than 3 mTorr, less than 2 mTorr, or even about 1.5 mTorr.

Embodiment 10 includes the method according to any of Embodiments 1 to 9, wherein the bulk piezoelectric layer comprises a hexagonal crystal structure piezoelectric material having a c-axis orientation distribution predominantly in a range of from 12 degrees to 52 degrees, or in a range of from 27 degrees to 37 degrees, or in a range of from 75 degrees to 90 degrees, relative to the normal of the face of the substrate.

Embodiment 11 includes the method according to any of Embodiments 1 to 10, wherein the bulk piezoelectric layer is about 1,000 Angstroms to about 30,000 Angstroms thick and wherein the thickness varies by less than 2 % over an area of the bulk piezoelectric layer.

Embodiment 12 includes the method according to any of Embodiments 1 to 11, wherein the first seed material, the second seed material and the bulk piezoelectric material are the same or different and are selected from metal nitrides, metal oxides, metal oxynitrides, metal carbides, refractory metals, and combinations thereof.

Embodiment 13 includes the method according to Embodiment 12, wherein materials of the first seed material, the second seed material and the bulk piezoelectric material are the same or different and are selected from aluminum nitride, titanium nitride, hafnium nitride, tantalum nitride, zirconium nitride, vanadium nitride, niobium nitride, gallium nitride, zinc oxide, tungsten oxide, hafnium oxide, molybdenum oxide, hafnium oxynitride, titanium oxynitride, tantalum oxynitride, titanium carbide, niobium carbide, tungsten carbide, tantalum carbide, zirconium, hafnium, tungsten, molybdenum, and combinations thereof.

Embodiment 14 is a structure comprising: a substrate comprising a wafer or a portion thereof, the substrate having a face that defines normal to the substrate; a pre-seed layer on at least a portion of the substrate, the pre-seed layer having a surface roughness from 1 nanometer (nm) to 10 nm; a seed layer on at least a portion of the pre-seed layer, the seed layer having a first c-axis tilt; and a bulk piezoelectric layer having a second c-axis tilt of about 35 degrees or greater and comprising an outer surface having a surface roughness of 4.5 nm or less.

Embodiment 15 includes the structures according to Embodiment 14, wherein the surface roughness of the pre-seed layer is from 3 nm to 5 nm, or even from 3 nm to 4 nm

Embodiment 16 includes the structures according to any of Embodiments 14 or 15, wherein the seed layer has a first c-axis tilt and the bulk piezoelectric layer has a second c-axis tilt that substantially aligns with the first c-axis tilt.

Embodiment 17 includes the structure according to Embodiment 16, wherein the second c-axis tilt is about 35 degrees to about 52 degrees.

Embodiment 18 includes the structure according to any of Embodiments 14 to 17, wherein the bulk piezoelectric layer comprises a hexagonal crystal structure piezoelectric material having a c-axis having an orientation distribution predominantly in a range of from 12 degrees to 52 degrees, or in a range of from 27 degrees to 37 degrees, or in a range of from 75 degrees to 90 degrees, relative to the normal of the face of the substrate.

Embodiment 19 includes the structure according to any of Embodiments 14 to 18, wherein the bulk piezoelectric layer is about 1,000 Angstroms to about 30,000 Angstroms thick and wherein the thickness varies by less than 2 % over an area of the bulk piezoelectric layer.

Embodiment 20 includes the structure according to any of Embodiments 14 to 19, wherein materials of the pre-seed layer, the seed layer and the bulk piezoelectric layer are the same or different and are selected from metal nitrides, metal oxides, metal oxynitrides, metal carbides, refractory metals, and combinations thereof.

Embodiment 21 includes the structure according to Embodiment 20, wherein materials of the pre-seed layer, the seed layer and the bulk piezoelectric layer are the same or different and are selected from aluminum nitride, titanium nitride, hafnium nitride, tantalum nitride, zirconium nitride, vanadium nitride, niobium nitride, gallium nitride, zinc oxide, tungsten oxide, hafnium oxide, molybdenum oxide, hafnium oxynitride, titanium oxynitride, tantalum oxynitride, titanium carbide, niobium carbide, tungsten carbide, tantalum carbide, zirconium, hafnium, tungsten, molybdenum, and combinations thereof.

Embodiment 22 is a bulk acoustic wave ("BAW") device comprising a piezoelectric structure prepared according to the method of any one of embodiments 1 to 13.

### Examples

### Comparative Example

FIG. 5 XRD pole figures were generated using blanket films on silicon test wafers. In general, a bottom electrode layer is deposited, followed by piezo stack growth and the x-ray diffractometer measurement.

FIG. 5 shows the AlN c-axis (002) XRD pole figure collected on baseline composite film (EG5504) consisting of seed and bulk layers and shows that it exhibits a tilt behavior of about 10°. However, current configuration of the deposition system should generate composite films with 33° c-axis tilt.

### Example 1

X-ray diffractometer was used to generate the pole figures depicted. The substrates had blanket stacks up to this point. Ensuing electrical data (FIG7) was extracted from same wafers by patterning a single top electrode.

FIGs. 6A, 6B, 6C and 6D show AlN (002) XRD pole figures and illustrate the progression of the c-axis tilt of the composite films deposited on short loop (EG5504) wafers as a function of the pre-seed thicknesses (FIG. 6A has a pre-seed thickness of 10 Angstroms (Å), FIG. 6B has a pre-seed thickness of 30 Å, FIG. 6C has a pre-seed thickness of 50 Å, and FIG. 6D has a pre-seed thickness of 70 Å). Note that all these wafers have received standard BE CMP processes. The eminent progression of the c-axis tilt can be explained by that introducing a thin layer of AlN deposited at high pressure provides a rough surface for the seed AlN to grow, thereby allowing crystallographic planes to align themselves with the incoming flux.

The corresponding longitudinal and shear piezoelectric coefficients along with the splits grown on virgin W bottom electrode are shown in the plots in FIG. 7. As seen in the plots, the longitudinal response is suppressed and shear response is improved best with the splits, wafer 5 and 6 that have received a pre-seed layer of 50 Å at high pressure. The improvement results in a superior performance with respect to the baseline, wafers 23 and 24.

Additionally, FIG. 8 shows S11 traces of wafer 5 and a comparison wafer (W24). The Longitudinal and shear modes of wafer 5 are indistinguishable. The shear mode of wafer 5 is greater than that of wafer 24. Note also that the shear mode of wafer 5 is comparable to longitudinal mode of wafer 24.

Although specific embodiments have been illustrated and described herein, it will be appreciated by those of ordinary skill in the art that a variety of alternate implementations can be substituted for the specific embodiments shown and described without departing from the invention as defined by the claims. It should be understood that this disclosure is not intended to be unduly limited by the illustrative embodiments and examples set forth herein and that such examples and embodiments are presented by way of example only with the invention as defined by the claims.

## Claims

1. A method of depositing piezoelectric
material onto a substrate (100, 4), the method comprising;
depositing a first seed material onto a wafer substrate (4) to form a pre-seed layer (31) on the wafer substrate before a seed layer (51), the wafer substrate having a face that defines a normal to the substrate, wherein the first seed material is deposited at a pressure of 10 mTorr to 20 mTorr, wherein the pre- seed layer has a surface roughness from 1 nm to 10 nm;
depositing a second seed material onto at least a portion of the pre-seed layer at an off-normal incidence angle to form the seed layer on at least a portion of the pre-seed layer; and
depositing a bulk piezoelectric material (52) onto at least a portion of the seed layer to form a bulk piezoelectric layer having a c-axis tilt of 35 degrees or greater and a surface roughness of 4.5 nm or less.

2. The method according to claim 1, wherein the first seed material is deposited at a pressure of 12 mTorr to 18 mTorr, 14 mTorr to 16 mTorr, or even 15 mTorr; wherein, optionally, the second seed material is deposited at a pressure of less than 5 mTorr, less than 3 mTorr, less than 2 mTorr, or even 1.5 mTorr.

3. The method according to any of claims 1 or 2, wherein the surface roughness of the pre-seed layer (31) is from 3 nm to 5 nm, or even from 3 nm to 4 nm.

4. The method according to any of claims 1 to 3, wherein the second seed material is deposited at an off-normal incidence angle of greater than 10 degrees, greater than 27 degrees, greater than 30 degrees, greater than 32 degrees, greater than 33 degrees, greater than 34 degrees, greater than 35 degrees, greater than 36 degrees, or greater than 40 degrees; wherein, optionally, the second seed material is deposited at an off-normal incidence angle of up to 85 degrees, up to 75 degrees, up to 65 degrees, up to 56 degrees, up to 52 degrees, up to 50 degrees, up to 49 degrees, or up to 48 degrees.

5. The method according to any of claims 1 to 4, wherein the bulk piezoelectric material (52) is deposited at an off-normal angle of incidence; wherein, optionally, the bulk piezoelectric material (52) is deposited at an off-normal incidence angle of 0 degrees, up to 5 degrees, up to about 10 degrees, up to 15 degrees, up to 20 degrees, up to 25 degrees, up to 30 degrees, up to 35 degrees, or up to 40 degrees.

6. The method according to any of claims 1 to 5, wherein the bulk piezoelectric material (52) is deposited at a pressure of less than 5 mTorr, less than 3 mTorr, less than 2 mTorr, or even 1.5 mTorr.

7. The method according to any of claims 1 to 6, wherein the bulk piezoelectric layer (52) comprises a hexagonal crystal structure piezoelectric material having a c-axis having an orientation distribution predominantly in a range of from 12 degrees to 52 degrees, or in a range of from 27 degrees to 37 degrees, or in a range of from 75 degrees to 90 degrees, relative to the normal of the face of the substrate.

8. The method according to any of claims 1 to 7, wherein the bulk piezoelectric layer (52) is 1,000 Angstroms to 30,000 Angstroms thick and wherein the thickness varies by less than 2 % over an area of the bulk piezoelectric layer.

9. The method according to any of claims 1 to 8, wherein the first seed material, the second seed material and the bulk piezoelectric material are the same or different and are selected from metal nitrides, metal oxides, metal oxynitrides, metal carbides, refractory metals, and combinations thereof.

10. A piezoelectric structure comprising:
a substrate (100, 4) comprising a wafer or a portion thereof, the substrate having a face (102) that defines normal to the substrate;
a seed layer (51) having a first c-axis tilt; and
a bulk piezoelectric layer (52) having a second c-axis tilt of 35 degrees or greater and comprising an outer surface having a surface roughness of 4.5 nm or less, **characterised by** further comprising a pre-seed layer (31) on at least a portion of the substrate, having a surface roughness from 1 nm to 10 nm, and wherein the seed layer disposed on at least a portion of the pre-seed layer.

11. The piezoelectric structure according to claim 10, wherein the surface roughness of the pre-seed layer (31) is from 3 nm to 5 nm, or even from 3 nm to 4 nm.

12. The piezoelectric structure according to any of claims 10 or 11, wherein the seed layer (51) has a first c-axis tilt and the bulk piezoelectric layer (52) has a second c-axis tilt that substantially aligns with the first c-axis tilt; wherein, optionally, the second c-axis tilt is 35 degrees to 52 degrees.

13. The piezoelectric structure according to any of claims 10 to 12, wherein the bulk piezoelectric layer (52) comprises a hexagonal crystal structure piezoelectric material having a c-axis having an orientation distribution predominantly in a range of from 12 degrees to 52 degrees, or in a range of from 27 degrees to 37 degrees, or in a range of from 75 degrees to 90 degrees, relative to the normal of the face of the substrate.

14. The piezoelectric structure according to any of claims 10 to 13, wherein the bulk piezoelectric layer (52) is 1,000 Angstroms to 30,000 Angstroms thick and wherein the thickness varies by less than 2 % over an area of the bulk piezoelectric layer.

15. The piezoelectric structure according to any of claims 10 to 14, wherein materials of the pre-seed layer (31), the seed layer (51) and the bulk piezoelectric layer (52) are the same or different and are selected from metal nitrides, metal oxides, metal oxynitrides, metal carbides, refractory metals, and combinations thereof.

## Patentansprüche

1. Verfahren zum Abscheiden von piezoelektrischem Material auf ein Substrat (100, 4), wobei das Verfahren Folgendes umfasst:
Abscheiden eines ersten Keimmaterials auf ein Wafersubstrat (4), um eine Vorkeimschicht (31) auf dem Wafersubstrat vor einer Keimschicht (51) zu bilden, wobei das Wafersubstrat eine Fläche aufweist, die eine normale zu dem Substrat definiert, wobei das erste Keimmaterial bei einem Druck von 10 mTorr bis 20 mTorr abgeschieden wird, wobei die Vorkeimschicht eine Oberflächenrauigkeit von 1 nm bis 10 nm aufweist;
Abscheiden eines zweiten Keimmaterials auf wenigstens einen Teil der Vorkeimschicht mit einem von der Normalen abweichenden Einfallswinkel, um die Keimschicht auf wenigstens einem Teil der Vorkeimschicht zu bilden; und Abscheiden eines piezoelektrischen Volumenmaterials (52) auf wenigstens einen Teil der Keimschicht, um eine piezoelektrische Volumenschicht mit einer Neigung der c-Achse von 35 Grad oder mehr und einer Oberflächenrauigkeit von 4,5 nm oder weniger zu bilden.

2. Verfahren nach Anspruch 1, wobei das erste Keimmaterial bei einem Druck von 12 mTorr bis 18 mTorr, 14 mTorr bis 16 mTorr oder sogar 15 mTorr abgeschieden wird; wobei optional das zweite Keimmaterial bei einem Druck von weniger als 5 mTorr, weniger als 3 mTorr, weniger als 2 mTorr oder sogar 1,5 mTorr abgeschieden wird.

3. Verfahren nach einem der Ansprüche 1 oder 2, wobei die Oberflächenrauhigkeit der Vorkeimschicht (31) von 3 nm bis 5 nm oder sogar von 3 nm bis 4 nm beträgt.

4. Verfahren nach einem der Ansprüche 1 bis 3, wobei das zweite Keimmaterial mit einem von der Normalen abweichenden Einfallswinkel von mehr als 10 Grad, mehr als 27 Grad, mehr als 30 Grad, mehr als 32 Grad, mehr als 33 Grad, mehr als 34 Grad, mehr als 35 Grad, mehr als 36 Grad oder mehr als 40 Grad abgeschieden wird; wobei optional das zweite Keimmaterial mit einem von der Normalen abweichenden Einfallswinkel von bis zu 85 Grad, bis zu 75 Grad, bis zu 65 Grad, bis zu 56 Grad, bis zu 52 Grad, bis zu 50 Grad, bis zu 49 Grad oder bis zu 48 Grad abgeschieden wird.

5. Verfahren nach einem der Ansprüche 1 bis 4, wobei das piezoelektrische Volumenmaterial (52) mit einem von der Normalen abweichenden Einfallswinkel abgeschieden wird; wobei optional das piezoelektrische Volumenmaterial (52) mit einem von der Normalen abweichenden Einfallswinkel von 0 Grad, bis zu 5 Grad, bis zu etwa 10 Grad, bis zu 15 Grad, bis zu 20 Grad, bis zu 25 Grad, bis zu 30 Grad, bis zu 35 Grad oder bis zu 40 Grad abgeschieden wird.

6. Verfahren nach einem der Ansprüche 1 bis 5, wobei das piezoelektrische Volumenmaterial (52) mit einem Druck von weniger als 5 mTorr, weniger als 3 mTorr, weniger als 2 mTorr oder sogar 1,5 mTorr abgeschieden wird.

7. Verfahren nach einem der Ansprüche 1 bis 6, wobei die piezoelektrische Volumenschicht (52) ein piezoelektrisches Material mit hexagonaler Kristallstruktur umfasst, das eine c-Achse mit einer Orientierungsverteilung überwiegend in einem Bereich von 12 Grad bis 52 Grad oder in einem Bereich von 27 Grad bis 37 Grad oder in einem Bereich von 75 Grad bis 90 Grad relativ zur Normalen der Fläche des Substrats aufweist.

8. Verfahren nach einem der Ansprüche 1 bis 7, wobei die piezoelektrische Volumenschicht (52) 1.000 Ångström bis 30.000 Ångström dick ist und wobei die Dicke um weniger als 2 % über einen Bereich der piezoelektrischen Volumenschicht variiert.

9. Verfahren nach einem der Ansprüche 1 bis 8, wobei das erste Keimmaterial, das zweite Keimmaterial und das piezoelektrische Volumenmaterial gleich oder verschieden sind und aus Metallnitriden, Metalloxiden, Metalloxinitriden, Metallcarbiden, Refraktärmetallen, und Kombinationen davon ausgewählt werden.

10. Piezoelektrische Struktur, die Folgendes umfasst:
ein Substrat (100, 4), das einen Wafer oder einen Teil davon umfasst, wobei das Substrat eine Fläche (102) aufweist, die eine Normale zu dem Substrat definiert;
eine Keimschicht (51) mit einer ersten c-Achsen-Neigung; und
eine piezoelektrische Bulk-Schicht (52), die eine zweite c-Achsen-Neigung von 35 Grad oder mehr aufweist und eine Außenfläche mit einer Oberflächenrauigkeit von 4,5 nm oder weniger umfasst,
**dadurch gekennzeichnet, dass** sie ferner eine Vorkeimschicht (31) auf wenigstens einem Teil des Substrats umfasst, die eine Oberflächenrauigkeit von 1 nm bis 10 nm aufweist, und wobei die Keimschicht auf wenigstens einem Teil der Vorkeimschicht angeordnet ist.

11. Piezoelektrische Struktur nach Anspruch 10, wobei die Oberflächenrauigkeit der Vorkeimschicht (31) von 3 nm bis 5 nm oder sogar von 3 nm bis 4 nm beträgt.

12. Piezoelektrische Struktur nach einem der Ansprüche 10 oder 11, wobei die Keimschicht (51) eine erste c-Achsen-Neigung aufweist und die piezoelektrische Volumenschicht (52) eine zweite c-Achsen-Neigung aufweist, die im Wesentlichen mit der ersten c-Achsen-Neigung ausgerichtet ist; wobei optional die zweite c-Achsen-Neigung 35 Grad bis 52 Grad beträgt.

13. Piezoelektrische Struktur nach einem der Ansprüche 10 bis 12, wobei die piezoelektrische Volumenschicht (52) ein piezoelektrisches Material mit hexagonaler Kristallstruktur umfasst, das eine c-Achse mit einer Orientierungsverteilung überwiegend in einem Bereich von 12 Grad bis 52 Grad oder in einem Bereich von 27 Grad bis 37 Grad oder in einem Bereich von 75 Grad bis 90 Grad relativ zur Normalen der Fläche des Substrats aufweist.

14. Piezoelektrische Struktur nach einem der Ansprüche 10 bis 13, wobei die piezoelektrische Volumenschicht (52) 1.000 Ångström bis 30.000 Ångström dick ist und wobei die Dicke um weniger als 2 % über einen Bereich der piezoelektrischen Volumenschicht variiert.

15. Piezoelektrische Struktur nach einem der Ansprüche 10 bis 14, wobei Materialien der Vorkeimschicht (31), der Keimschicht (51) und der piezoelektrischen Volumenschicht (52) gleich oder verschieden sind und aus Metallnitriden, Metalloxiden, Metalloxinitriden, Metallcarbiden, Refraktärmetallen und Kombinationen davon ausgewählt sind.

## Revendications

1. Procédé de dépôt de matériau piézoélectrique sur un substrat (100, 4), le procédé comprenant :
le dépôt d'un premier matériau germe sur un substrat en tranche (4) pour former une couche de prégermination (31) sur le substrat en tranche avant une couche de germination (51), le substrat en tranche ayant une face qui définit une normale au substrat, le premier matériau germe étant déposé à une pression de 10 mTorr à 20 mTorr, la couche de prégermination présentant une rugosité de surface de 1 nm à 10 nm ;
le dépôt d'un deuxième matériau germe sur au moins une partie de la couche de prégermination selon un angle d'incidence par rapport à la normale pour former la couche de germination sur au moins une partie de la couche de prégermination ; et
le dépôt d'un matériau piézoélectrique massif (52) sur au moins une partie de la couche de germination pour former une couche piézoélectrique massive présentant une inclinaison de l'axe c de 35 degrés ou plus et une rugosité de surface de 4,5 nm ou moins.

2. Procédé selon la revendication 1, dans lequel le premier matériau germe est déposé à une pression de 12 mTorr à 18 mTorr, 14 mTorr à 16 mTorr, voire 15 mTorr ; éventuellement dans lequel le deuxième matériau germe est déposé à une pression inférieure à 5 mTorr, inférieure à 3 mTorr, inférieure à 2 mTorr, voire de 1,5 mTorr.

3. Procédé selon l'une quelconque des revendications 1 et 2, dans lequel la rugosité de surface de la couche de prégermination (31) est de 3 nm à 5 nm, voire de 3 nm à 4 nm.

4. Procédé selon l'une quelconque des revendications 1 à 3, dans lequel le deuxième matériau germe est déposé selon un angle d'incidence par rapport à la normale supérieur à 10 degrés, supérieur à 27 degrés, supérieur à 30 degrés, supérieur à 32 degrés, supérieur à 33 degrés, supérieur à 34 degrés, supérieur à 35 degrés, supérieur à 36 degrés, ou supérieur à 40 degrés ; éventuellement dans lequel le deuxième matériau germe est déposé selon un angle d'incidence par rapport à la normale allant jusqu'à 85 degrés, jusqu'à 75 degrés, jusqu'à 65 degrés, jusqu'à 56 degrés, jusqu'à 52 degrés, jusqu'à 50 degrés, jusqu'à 49 degrés, ou jusqu'à 48 degrés.

5. Procédé selon l'une quelconque des revendications 1 à 4, dans lequel le matériau piézoélectrique massif (52) est déposé selon un angle d'incidence par rapport à la normale ; éventuellement dans lequel le matériau piézoélectrique massif (52) est déposé selon un angle d'incidence par rapport à la normale de 0 degré, allant jusqu'à 5 degrés, jusqu'à environ 10 degrés, jusqu'à 15 degrés, jusqu'à 20 degrés, jusqu'à 25 degrés, jusqu'à 30 degrés, jusqu'à 35 degrés, ou jusqu'à 40 degrés.

6. Procédé selon l'une quelconque des revendications 1 à 5, dans lequel le matériau piézoélectrique massif (52) est déposé à une pression inférieure à 5 mTorr, inférieure à 3 mTorr, inférieure à 2 mTorr, voire de 1,5 mTorr.

7. Procédé selon l'une quelconque des revendications 1 à 6, dans lequel la couche piézoélectrique massive (52) comprend un matériau piézoélectrique de structure cristalline hexagonale ayant un axe c présentant une distribution d'orientation principalement dans une plage allant de 12 degrés à 52 degrés, ou dans une plage allant de 27 degrés à 37 degrés, ou dans une plage allant de 75 degrés à 90 degrés, par rapport à la normale à la face du substrat.

8. Procédé selon l'une quelconque des revendications 1 à 7, dans lequel la couche piézoélectrique massive (52) fait 1000 angströms à 30 000 angströms d'épaisseur et dans lequel l'épaisseur varie de moins de 2 % sur une superficie de la couche piézoélectrique massive.

9. Procédé selon l'une quelconque des revendications 1 à 8, dans lequel le premier matériau germe, le deuxième matériau germe et le matériau piézoélectrique massif sont identiques ou différents et sont choisis parmi les nitrures métalliques, les oxydes métalliques, les oxynitrures métalliques, les carbures métalliques, les métaux réfractaires, et les combinaisons de ceux-ci.

10. Structure piézoélectrique comprenant :
un substrat (100, 4) comprenant une tranche ou une partie de celle-ci, le substrat ayant une face (102) qui définit une normale au substrat ;
une couche de germination (51) présentant une première inclinaison de l'axe c ; et
une couche piézoélectrique massive (52) présentant une deuxième inclinaison de l'axe c de 35 degrés ou plus et comprenant une surface externe présentant une rugosité de surface de 4,5 nm ou moins,
**caractérisée en ce qu'**elle comprend en outre une couche de prégermination (31) sur au moins une partie du substrat, présentant une rugosité de surface de 1 nm à 10 nm, et dans laquelle la couche de germination est disposée sur au moins une partie de la couche de prégermination.

11. Structure piézoélectrique selon la revendication 10, dans laquelle la rugosité de surface de la couche de prégermination (31) est de 3 nm à 5 nm, voire de 3 nm à 4 nm.

12. Structure piézoélectrique selon l'une quelconque des revendications 10 et 11, dans laquelle la couche de germination (51) présente une première inclinaison de l'axe c et la couche piézoélectrique massive (52) présente une deuxième inclinaison de l'axe c qui s'aligne sensiblement sur la première inclinaison de l'axe c ; éventuellement dans laquelle la deuxième inclinaison de l'axe c est de 35 degrés à 52 degrés.

13. Structure piézoélectrique selon l'une quelconque des revendications 10 à 12, dans laquelle la couche piézoélectrique massive (52) comprend un matériau piézoélectrique de structure cristalline hexagonale ayant un axe c présentant une distribution d'orientation principalement dans une plage allant de 12 degrés à 52 degrés, ou dans une plage allant de 27 degrés à 37 degrés, ou dans une plage allant de 75 degrés à 90 degrés, par rapport à la normale à la face du substrat.

14. Structure piézoélectrique selon l'une quelconque des revendications 10 à 13, dans laquelle la couche piézoélectrique massive (52) fait 1000 angströms à 30 000 angströms d'épaisseur et dans laquelle l'épaisseur varie de moins de 2 % sur une superficie de la couche piézoélectrique massive.

15. Structure piézoélectrique selon l'une quelconque des revendications 10 à 14, dans laquelle les matériaux de la couche de prégermination (31), de la couche de germination (51) et de la couche piézoélectrique massive (52) sont identiques ou différents et sont choisis parmi les nitrures métalliques, les oxydes métalliques, les oxynitrures métalliques, les carbures métalliques, les métaux réfractaires, et les combinaisons de ceux-ci.
